# EUROPÄISCHE PATENTSCHRIFT

(11) **EP 1 987 536 B1**
(45) Veröffentlichungstag und Bekanntmachung des Hinweises auf die Patenterteilung: **07.07.2010**
(21) Anmeldenummer: 06841523.1
(22) Anmeldetag: 20.12.2006
(51) Int. Cl.: H01L 23/31, H01L 21/56

(54) **VERFAHREN ZUR SELEKTIVEN HERSTELLUNG VON FOLIENLAMINATEN ZUM PACKAGING UND ZUR ISOLATION VON UNGEHÄUSTEN ELEKTRONISCHEN BAUELEMENTEN UND FUNKTIONSSTRUKTUREN**
METHOD FOR SELECTIVELY PRODUCING FILM LAMINATES FOR PACKAGING AND FOR INSULATING UNPACKAGED ELECTRONIC COMPONENTS AND FUNCTIONAL PATTERNS
PROCÉDÉ DE FABRICATION SÉLECTIVE DE STRATIFIÉS EN FEUILLES POUR L'EMBALLAGE ET POUR L'ISOLATION DE COMPOSANTS ÉLECTRONIQUES ET DE STRUCTURES FONCTIONNELLES SANS BOÎTIERS

(30) Priorität: 20.02.2006 DE 102006007790; 16.03.2006 DE 102006012232
(43) Veröffentlichungstag der Anmeldung: 05.11.2008
(73) Patentinhaber: SIEMENS AKTIENGESELLSCHAFT, 80333 München (DE)
(72) Erfinder: NAUNDORF, Jörg, 80802 München (DE); WEIDNER, Karl, 81245 München (DE); WULKESCH, Hans, 81739 München (DE)
(86) Internationale Anmeldenummer: PCT/EP2006/070026
(87) Internationale Veröffentlichungsnummer: WO 2007/096018

(56) Entgegenhaltungen:
- DE-U1- 20 011 590
- US-A1- 2001 039 071
- US-B1- 6 492 194

## Beschreibung

Die Erfindung betrifft ein Verfahren zum Beschichten von Oberflächenbereichen auf einem Substrat angeordneter Funktionsstrukturen und/oder von Oberflächenbereichen auf dem Substrat angeordneter elektronischer Bauelemente. Den Beschichtungen sind verschiedene Funktionen zugeordnet, diese können beispielsweise elektrische oder thermische Isolierungen oder auch ein mechanischer Schutz sein. Nachfolgend sind als Beispiele für elektronische Bauelemente Halbleiterchips genannt. Halbleiterchips sind alle herkömmlichen Halbleiterbauelemente. Funktionsstrukturen sind alle einem bestimmten Zweck zugeordneten Gebilde, die auf einem Substrat angeordnet sind.

Gemäß herkömmlichen Verfahren wird ein Beschichten ausgeführt, bei dem in der entsprechenden Funktionsebene lediglich eine Isolationsschicht auf einem Substrat beziehungsweise auf Halbleiterchips derart erzeugt wird, dass die Eigenschaften der Isolierung an unterschiedliche Funktionsstrukturen beziehungsweise Halbleiterchips angepasst sind. Eine Anpassung der einen Isolationsschicht an unterschiedliche Funktionsstrukturen beziehungsweise Halbleitchips erfolgt lediglich angenähert. Soll beispielsweise eine Isolationsschicht, hinsichtlich deren elektrisch isolierenden Eigenschaften verschiedene Spannungsebenen von Einzelkomponenten berücksichtigen, muss die Dicke der einen Isolationsschicht der höchsten Spannungsebene angepasst sein. Eine Anpassung elektrischer, thermischer und thermo-mechanischer Eigenschaften für die gesamte Baugruppe ist somit nur begrenzt möglich. Das heißt z. B. für die Einzelkomponenten niedriger Spannungsebenen sind dünnere Dicken einer Isolationsschicht ausreichend. Die eine Isolationsschicht ist auf herkömmliche Weise den extremsten Anforderungen beispielsweise an die Durchschlagsfestigkeit angepasst. Dieser Nachteil ist ebenso bei der einen Isolationsschicht für thermische Isolierungen von unterschiedlichen Einzelkomponenten gegeben. Auch in diesem Fall muss die thermische Isoliereigenschaften der einen Isolationsschicht der extremsten Einzelkomponente angepasst sein. Dies betrifft ebenso thermo-mechanische Anforderungen an die Eigenschaften der einen Isolationsschicht. Die eine Isolationsschicht kann auch derart angepasst sein, dass ein Mittelwert von Eigenschaften ausgewählt wird, beispielsweise hinsichtlich der dielektrischen Anforderungen an die eine Isolationsschicht. Auf die herkömmliche Weise ist die eine Isolationsschicht ungenügend an die Anforderungen angepasst, die durch die Funktionsstruktur und/oder den Halbleiterchip gegeben sind. Eine jeweilige Anpassung der einen Isolationsschicht kann zu extrem oder ungenügend erfolgen. Auf herkömmliche Weise wird ein Isoliermaterial verwendet, das den unterschiedlichen Anforderungen von Einzelkomponenten lediglich nahe kommt. Eine herkömmliche Beschichtung mittels des einen Isoliermaterials erfolgt beispielsweise mittels einer Sprühbelackung, mittels Physical Vapour Deposition (PVD) oder Tauchverfahren, mittels Laminieren oder als Pastendruck der mittels Wärme ausgehärtet wird (Glob-Top). Aufgrund der spezifischen Anforderungen durch Funktionsstrukturen und/oder Halbleiterchips ist die Verwendung lediglich eines Isoliermaterials in einer Funktionsebene nachteilig.

Die DE 200 11 590 U1 offenbart ein Halbleiterchip-Modul, in welchem wenigstens ein Halbleiterchip auf einen Träger befestigt und mit diesem elektrisch leitend kontaktiert ist. Das Halbleiterchip-Modul ist **dadurch gekennzeichnet, dass** auf die den Träger abgewandte Oberfläche des Halbleiterchips eine aus einer Klebeschicht und einer Elastomerschicht bestehende Schutzfolie mit der Klebeschicht voran aufgebracht ist und diese Schutzfolie allseitig über die Oberfläche des Halbleiterchips übersteht.

Die US 6 492 194 B1 offenbart ein Verfahren zur Einhäusung von elektronischen Komponenten, einschließlich der Befestigung von zumindest einer Elektronikkomponente auf deren aktiven Seite auf einer Basis, wobei die Basis elektrische Kontakte auf einer externen Seite und Verbindungsflächen auf einer Seite entgegengesetzt der externen Seite einschließt und eine erste Serie von Durchgangsöffnungen einschließt, die die elektrischen Kontakte und die kleinen Verbindungsflächen und eine zweite Folge von Öffnungen zur Verwendung zur Luftabsaugung einschließt.

Die US 2001/0039071 A1 offenbart eine Platte auf einem Chipgehäuse mit einem isolierenden Substrat mit einer Schaltung darauf und einer Öffnung durch dieses hindurch. Ein Halbleitermaterial aufweisender Stempel wird auf das Substrat angeklebt und elektrisch zu der Schaltung angeschlossen, mit einer Vielzahl von elektrischen Verbindungen, die sich durch die Öffnung erstrecken. Eine Metallfolie ist im körperlichen Kontakt mit zumindest einem Abschnitt des Stempels.

Es ist Aufgabe der vorliegenden Erfindung auf einem Substrat mit Funktionsstrukturen und/oder Halbleiterbauelementen eine Isolierung derart wirksam zu verbessern, dass diese hinsichtlich deren Eigenschaften an unterschiedliche Anforderungen von Funktionsstrukturen und/oder Halbleiterchips besser angepasst ist.

Die Aufgabe wird durch ein Verfahren gemäß dem Hauptanspruch gelöst.

Bei der Aufbau- und Verbindungstechnik dreidimensionaler Baugruppen werden nun individuell angepasste Isoliermaterialien in einer Funktionsebene verwendet. Dies ist insbesondere für eine Verbindungstechnik auf der Grundlage von planaren elektrischen Kontaktierungen, für Folienpackages, für ungehäuste Chips sowie für eine Integration von passiven und aktiven Bauelementen vorteilhaft. Indem für jeden Oberflächenbereich von Funktionsstrukturen und/oder von elektronischen Bauelementen beziehungsweise Halbleiterchips jeweils eine individuelle Folie verwendet wird, deren Eigenschaften des Kunststoffmaterials an die Funktion der Folie oder an die durch die Funktionsstruktur und/oder den Halbleiterchip gegebenen Anforderungen angepasst sind, kann die Isolierung hinsichtlich beispielsweise der dielektrischen, thermischen und thermo-mechanischen Anforderungen der Einzelbauelemente beziehungsweise Funktionsstrukturen angepasst werden. Die Folien können Kunststofffolien sein. Beispiele für Folienmaterialien einer Kunststofffolie sind Polyimide, bei denen eine Laminierung mittels Acrylklebern erfolgen kann. Bei Polyimiden existiert eine große Auswahl an Substraten, Deck- und Verbundfolien. Die Schmelzpunkte liegen bei etwa 260°C. Weitere geeignete Kunststoffe sind sogenannte LC- (Liquid Crystal) Polymere, die hohe Schmelztemperaturen aufweisen und lediglich kleine Wassermengen aus der Umgebung aufnehmen. Weitere geeignete Kunststoffe sind Materialien mit Aramidverstärkung. Derartige Materialien sind beispielsweise Duramid oder Arlon 65 GT.

Funktionen einer Folie können beispielsweise die elektrische oder thermische Isolierung von Hochspannungsbauteilen oder Niederspannungsbauteilen, die Erzeugung von Dielektrika oder der mechanische Schutz beispielsweise gegen Verschmutzung oder mechanischen Belastungen sein. Die Erfindung ist besonders vorteilhaft bei der insbesondere auf der Grundlage des so genannten High Thermal Dielectric Encapsulation erfolgenden Einkapselung von Insulated Gate-Feldeffekttransistoren (IGFET), Metalloxidhalbleiter-Feldeffekttransistoren (MOSFET), integrierten Schaltkreisen auf Siliziumbasis (Si-IC), Induktivitäten beziehungsweise Kapazitäten oder IGBTs. Ein Insulated Gate Bipolar Transistor (IGBT) ist ein Halbleiterbauelement, welches zunehmend in der verwendet wird, da es die Vorteile des Bipolartransistors (günstiges Durchlassverhalten, große Sperrspannung) und die Vorteile
eines Feldeffekttransistors (nahezu leistungslose Ansteuerung) vereinigt. Vorteilhaft ist auch eine gewisse Robustheit gegenüber Kurzschlüssen, da der IGBT den Laststrom begrenzt.
IGBT werden unter anderem im Hochleistungsbereich eingesetzt, da sie über eine große Sperrspannung (derzeit bis 6,6 kV) verfügen und für große Strömstärken (bis etwa 3 kA) verwendbar sind.

Es werden mehrere funktionsangepasste Isoliermaterialien in Form von Laminatbereichen beziehungsweise Laminatinseln in einer Ebene aufgebracht. Die Herstellung der selektiv aufgebrachten Folienlaminate erfolgt mittels eines kombinierten Laser-Laminierschrittes. Dabei werden die Folien entsprechend der Bauteilpositionen per Laser geschnitten und gleichzeitig über eine Verschmelzung am Folienrand auf den Bauteilen beziehungsweise auf dem Substrat fixiert. Eine Fixierung der Folie während des Laserschnittes erfolgt mittels eines Vakuumtisches. Abschließend werden die Folien auf den jeweiligen Oberflächenbereichen auflaminiert. Ein verbleibender Folienrahmen kann entfernt und die nächste Folie kann analog der weiteren Bauteilpositionen gelasert werden.

Die Verwendung von selektiv hergestellten Folienlaminaten, insbesondere in einer Funktionsebene, führt zu einer erhöhten Gestaltungsfreiheit hinsichtlich beispielsweise dielektrischer, thermischer oder thermo-mechanischer Anforderungen an das Isoliermaterial. Daraus ergeben sich insbesondere Vorteile im Hinblick auf die Zuverlässigkeit und die Integrationsmöglichkeiten verschiedenartiger Bauelemente beziehungsweise Funktionsstrukturen. Des Weiteren können individuell angepasste Materialumhüllungen, beispielsweise als mechanischer Schutz, (Folienpackages) für ungehäuste Halbleiterchips beziehungsweise Funktionsstrukturen hergestellt werden.

Weitere vorteilhafte Ausgestaltungen ergeben sich aus den Unteransprüchen.

Gemäß einer vorteilhaften Ausgestaltung wird auf Oberflächenbereichen der Funktionsstruktur beziehungsweise Halbleiterchips mit jeweils gleichen Anforderungen an die Eigenschaften des Kunststoffmaterials der Folie, anstelle einzelner Folien, jeweils eine gemeinsame homogene einstückige Folie mittels eines Vakuums fixiert. Damit kann eine einzige Folie mit homogenen Eigenschaften auf alle relevanten Oberflächenbereiche aufgelegt und fixiert werden. Nachdem alle Folienbereiche mittels eines Lasers geschnitten und mittels Verschmelzen fixiert wurden, kann das Auflaminieren der Folien auf den jeweiligen Oberflächenbereichen ausgeführt werden.

Es kann eine weitere homogene Folie für weitere Oberflächenbereiche mit jeweils gleichen Anforderungen aufgelegt und fixiert werden. Dies kann beliebig oft erfolgen.

Gemäß einer weiteren vorteilhaften Ausgestaltung sind Funktionsstrukturen als Leiterbahnen, Widerstände beziehungsweise Kondensatoren erzeugt. Leiterbahnen und Widerstände können beispielsweise als flächige Gebilde mit unterschiedlichen Breiten erzeugt sein. Auf einem Bereiche einer Funktionsstruktur kann eine jeweilige Folie auflaminiert werden.

Gemäß einer weiteren vorteilhaften Ausgestaltung sind die Halbleiterchips beispielsweise Transistoren, integrierte Schaltungen, Induktivitäten und/oder Kapazitäten. Auf diese Weise sind die Isolierfolien vielseitig verwendbar.

Eine Anpassung der Eigenschaften des Kunststoffmaterials an die durch die Funktionsstruktur beziehungsweise den Halbleiterchip vorgegebenen Anforderungen beeinflussen die Eigenschaften der Folie hinsichtlich deren dielektrischen, thermischen und/oder thermo-mechanischen Eigenschaften. Weitere Eigenschaften können chemische oder physikalische Stabilität, beispielsweise gegen Feuchte und dergleichen sein.

Gemäß einer weiteren vorteilhaften Ausgestaltung werden die Folie als Gehäuse und/oder generell als Isolierungen für Funktionsstrukturen und/oder Halbleiterchips verwendet.

Gemäß einer weiteren vorteilhaften Ausgestaltung liegen die auflaminierten Folien in einer Funktionsebene. Auf diese Weise ist das Auflaminieren besonders einfach.

Gemäß einer weiteren bevorzugten Ausgestaltung werden nach dem Schneiden mittels Laser die über die Form der Oberflächenbereiche hinausgehende Folienreste, beispielsweise mittels einer Gasströmung, entfernet. Das Entfernen kann ebenso manuell erfolgen.

Die Erfindung wird anhand von Ausführungsbeispielen in Verbindung mit den Figuren näher beschrieben. Es zeigen:
- Figur 1: ein erstes Ausführungsbeispiel einer erzeugten Vor- richtung;
- Figur 2: ein zweites Ausführungsbeispiel einer erzeugten Vor- richtung;
- Figur 3: ein drittes Ausführungsbeispiel einer erzeugten Vor- richtung.

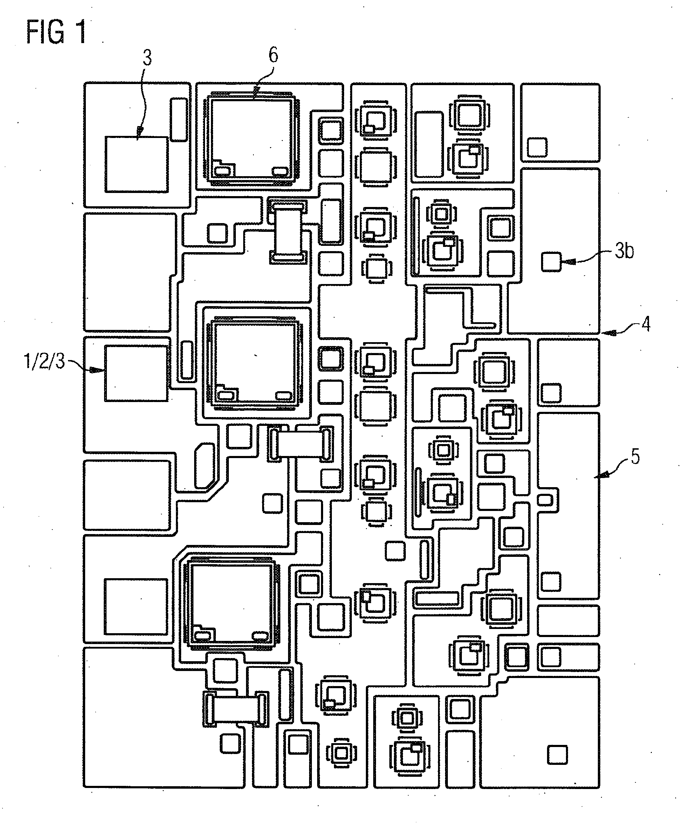

Figur 1 zeigt selektiv hergestellte Folienstrukturen 5 nach einem ersten Laserschnitt. Die Figur 1 zeigt die Folienstrukturen beziehungsweise Folienbereiche 1 vor dem Auflaminieren der Folien 3, 3a, 3b auf den jeweiligen Folienbereich 1. Die Folienbereiche 1 lassen sich genau positionieren, und zwar auf 50 µm genau. Die Folienbereiche 1 werden auf den Oberflächenbereichen 2 mittels Verschmelzen am Folienbereichsrand fixiert. Abschließend erfolgt ein Auflaminieren der an die Anforderung angepassten Folien 3, 3a, 3b auf den jeweiligen Oberflächenbereichen 2.

Figur 1 zeigt mit Folienbereichen 1 beschichtete dazugehörige Oberflächenbereiche 2, wobei die Folienbereiche 1 entlang der Schnittlinien mittels geschmolzener Randbereiche der Folie 3, 3a, 3b auf den Oberflächenbereichen 2 fixiert sind. Folienbereiche 1 beschichten dazugehörige Oberflächenbereiche 2. Die Folienbereiche 1 besitzen unterschiedliche Formen und Größen entsprechend den zu beschichtenden Oberflächenbereichen 2. Es können nach dem ersten Laserschnitt weitere Isolierschichten beziehungsweise Isolierfolien beziehungsweise Folien 3, 3a, 3b aufgebracht werden. Abschließend erfolgt das eigentliche Auflaminieren der Folien 3, 3a, 3b auf den jeweiligen Oberflächenbereichen 2. Die Folienbereiche 1 können beliebige Formen aufweisen.

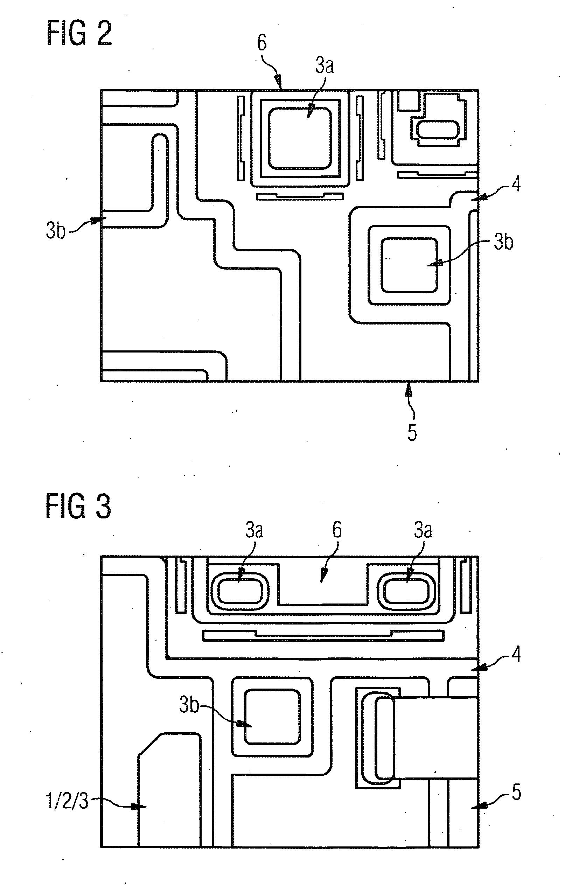

Figur 2 zeigt ein weiteres Ausführungsbeispiel hergestellter Folienstrukturen 1 auf Halbleiterchip- und Substratebene. Es werden zwei unterschiedliche Folienmaterialien gezeigt, die bereits auf den jeweiligen Oberflächenbereich auflaminiert wurden. Figur 2 zeigt unterschiedliche Folien 3a und 3b.

Figur 3 zeigt ein weiteres Ausführungsbeispiel von auf jeweiligen Oberflächenbereichen 2 auflaminierten Folien 3a, die von auflaminierten Folien 3b hinsichtlich ihrer Eigenschaften verschieden sind. Figur 3 zeigt die hergestellten Folienstrukturen auf Chip- und Substratebene mit zwei unterschiedlichen Folienmaterialien nach dem Auflaminieren.

Die Formen der Folienbereiche 1 und der Oberflächenbereiche 2 können beliebige Formen aufweisen. Die Folien 3, 3a, 3b können ebenso zur Einhäusung von Funktionsstrukturen 5 beziehungsweise Halbleiterchips 6 verwendet werden.

## Patentansprüche

1. Verfahren zum Beschichten mit Folien, denen verschiedene Funktionen zugeordnet sind, von Oberflächenbereichen (2) auf einem Substrat (4) angeordneter Funktionsstrukturen (5) und/oder von Oberflächenbereichen (2) auf dem Substrat (4) angeordneter elektronischer Bauelemente (6) mit den Schritten
- mittels eines Vakuums erfolgendes Fixieren jeweils einer Folie (3, 3a, 3b) aus isolierendem Kunststoffmaterial auf jeweils einen Oberflächenbereich (2) einer Funktionsstruktur (5) oder eines elektronischen Bauelements (6),
- mittels eines Lasers erfolgendes Schneiden der Folien (3, 3a, 3b) in der Form des jeweiligen Oberflächenbereichs (2), bei gleichzeitigem weiteren Fixieren der Folien (3, 3a, 3b) auf den Oberflächenbereichen (2) mittels Verschmelzens der Folien (3, 3a, 3b) mit den Oberflächenbereichen (2) entlang der Schnittlinien,
- Auflaminieren der Folien (3, 3a, 3b) auf den jeweiligen Oberflächenbereichen (2),
- wobei für jeden Oberflächenbereich (2) eine Folie (3, 3a, 3b) verwendet wird, deren Eigenschaften des Kunststoffmaterials an die Funktion der Folie (3, 3a, 3b) angepasst sind.

2. Verfahren nach Anspruch 1,
**dadurch gekennzeichnet, dass**
die Funktionsstrukturen (5) Leiterbahnen, Widerstände und/oder Kondensatoren sind.

3. Verfahren nach Anspruch 1 oder 2,
**dadurch gekennzeichnet, dass**
die elektronischen Bauelemente (6) Transistoren, integrierte Schaltungen, Induktivitäten, Widerstände und/oder Kapazitäten sind.

4. Verfahren nach einem oder mehreren der Ansprüche 1 bis 3,
**dadurch gekennzeichnet, dass**
die Eigenschaften dielektrische, thermische und/oder thermo-mechanische sind.

5. Verfahren nach einem oder mehreren der Ansprüche 1 bis 4,
**dadurch gekennzeichnet, dass**
die Folien (3, 3a, 3b) Gehäuse und/oder Isolierungen für Funktionsstrukturen (5) und/oder elektronische Bauelemente (6) erzeugen.

6. Verfahren nach einem oder mehreren der Ansprüche 1 bis 5,
**dadurch gekennzeichnet, dass**
die Folien (3, 3a, 3b) in einer Ebene auflaminierte Oberflächenbereiche erzeugen.

7. Verfahren nach einem oder mehreren der Ansprüche 1 bis 6,
**gekennzeichnet durch**
nach dem Schneiden erfolgendes Entfernen der über die Form der Oberflächenbereiche (2) hinaus gehenden Folienreste, beispielsweise mittels einer Gasströmung.

## Claims

1. Method for coating surface regions (2) of functional patterns (5) arranged on a substrate (4) and/or of surface regions (2) of electronic components (6) arranged on the substrate (4), with films, to which different functions are assigned, with the following steps:
- attaching by vacuum one film (3, 3a, 3b) of insulating plastic material in each case to one corresponding surface region (2) of a functional pattern (5) or of an electronic component (6),
- laser cutting the films (3, 3a, 3b) in the form of the respective surface region (2), and simultaneously further attaching the films (3, 3a, 3b) onto the surface regions (2) by melting the films (3, 3a, 3b) with surface regions (2) along the lines of cut,
- Laminating the films (3, 3a, 3b) onto the respective surface regions (2),
- wherein a film (3, 3a, 3b), in which the properties of the plastic material are adapted to the function of said film (3, 3a, 3b), is used for each surface region (2).

2. Method according to claim 1,
**characterised in that**
the functional patterns (5) are conductors, resistors and/or capacitors.

3. Method according to claim 1 or 2,
**characterised in that**
the electronic components (6) are transistors, integrated circuits, inductors, resistors and/or capacitors.

4. Method according to one or more of the claims 1 to 3,
**characterised in that**
the properties are dielectric, thermal and/or thermomechanical.

5. Method according to one or more of the claims 1 to 4,
**characterised in that**
the films (3, 3a, 3b) create packages and/or insulations for functional patterns (5) and/or electronic components (6).

6. Method according to one or more of the claims 1 to 5,
**characterised in that**
the films (3, 3a, 3b) create surface regions laminated in a single level.

7. Method according to one or more of the claims 1 to 6,
**characterised by**
the residual film extending beyond the shape of the surface regions (2) being removed, for example by a gas stream, after the laser cutting step.

## Revendications

1. Procédé pour revêtir de feuilles auxquelles sont attribuées différentes fonctions, des zones de surface (2) de structures fonctionnelles (5) disposées sur un substrat (4) et/ou des zones de surface (2) de composants électroniques (6) disposés sur le substrat (4), comprenant les étampes :
- au moyen d'un vide, fixer à chaque fois une feuille (3, 3a, 3b) en matière plastique isolante sur à chaque fois une zone de surface (2) d'une structure fonctionnelle (5) ou d'un composant électronique (6),
- au moyen d'un laser, couper les feuilles (3, 3a, 3b) selon la forme de la zone de surface (2) respective, tout en continuant à fixer les feuilles (3, 3a, 3b) sur les zones de surface (2) au moyen d'un assemblage par fusion desdites feuilles (3, 3a, 3b) avec lesdites zones de surface (2) le long des lignes de coupe,
- laminer les feuilles (3, 3a, 3b) sur les zones de surface (2) respectives,
- pour chaque zone de surface (2) étant utilisée une feuille (3, 3a, 3b) dont les propriétés de la matière plastique sont adaptées à la fonction de la feuille (3, 3a, 3b).

2. Procédé selon la revendication 1,
**caractérisé en ce que**
les structures fonctionnelles (5) sont des pistes conductrices, des résistances et/ou des condensateurs.

3. Procédé selon la revendication 1 ou 2,
**caractérisé en ce que**
les composants électroniques (6) sont des transistors, des circuits intégrés, des inductances, des résistances et/ou des capacités.

4. Procédé selon une ou plusieurs des revendications 1 à 3,
**caractérisé en ce que**
les propriétés sont des propriétés diélectriques, thermiques et/ou thermomécaniques.

5. Procédé selon une ou plusieurs des revendications 1 à 4,
**caractérisé en ce que**
les feuilles (3, 3a, 3b) produisent des boîtiers et/ou des isolations pour des structures fonctionnelles (5) et/ou des composants électroniques (6).

6. Procédé selon une ou plusieurs des revendications 1 à 5,
**caractérisé en ce que**
les feuilles (3, 3a, 3b) produisent des zones de surface appliquées par laminage dans un plan.

7. Procédé selon une ou plusieurs des revendications 1 à 6,
**caractérisé par**
une élimination, après la coupe, des restes de feuilles qui dépassent la forme des zones de surface (2), par exemple au moyen d'un flux de gaz.
